# EUROPÄISCHE PATENTSCHRIFT

(11) **EP 0 335 122 B1**
(45) Veröffentlichungstag und Bekanntmachung des Hinweises auf die Patenterteilung: **23.08.1995**
(21) Anmeldenummer: 89103629.5
(22) Anmeldetag: 02.03.1989
(51) Int. Cl.: H01J 37/302, H01J 37/305

(54) **Einrichtung und Verfahren für die Steuerung und Überwachung eines Elektronenstrahls für die Metallbearbeitung**
Device and procedure for controlling and monitoring electron beam for processing metals
Dispositif et procédé le commande et de contrôle d'un faisceau d'électrons pour le travail des métaux

(30) Priorität: 26.03.1988 DE 3810391
(43) Veröffentlichungstag der Anmeldung: 04.10.1989
(73) Patentinhaber: LEYBOLD AKTIENGESELLSCHAFT, D-63450 Hanau (DE)
(72) Erfinder: Bittenbrünn, Harald, D-6450 Hanau (DE); Thomas, Friedrich-Werner, Dr., D-6460 Gelnhausen 2 (DE); Thorn, Gernot, Dipl.-Ing., D-6450 Hanau (DE)
(74) Vertreter: Schickedanz, Willi, Dipl.-Ing.

(56) Entgegenhaltungen:
- EP-A- 0 222 219
- FR-A- 1 476 148
- OPTIK, vol. 77, no. 4, November 1987, Stuttgart, DE, Seiten 156-170 ; W. DIETRICH et al. : "Strahlführung und Leistungssteuerung von Elektronenstrahlkanonen bis 600kW und deren Einsatz in der industriellen Produktion"

## Beschreibung

Die Erfindung betrifft eine Einrichtung für die Steuerung und Überwachung eines ablenkbaren Elektronenstrahls für die Metallbearbeitung, zum Beispiel Härten, Schmelzen, Verdampfen etc.

Für die Erzeugung hochreiner Metalle, wie sie beispielsweise im Flugzeugbau benötigt werden, sind Hochvakuum-Elektronenstrahlschmelzanlagen besonders geeignet.

Die Skala der in Elektronenstrahlschmelzanlagen geschmolzenen und gereinigten Metalle reicht von den radioaktiven Metallen über die Buntmetalle, verschiedene Stahlqualitäten bis zu den reaktiven und refraktären Metallen und deren Legierungen.

Was die Qualität eines mittels Elektronenstrahlen geschmolzenen Blocks betrifft, die gekennzeichnet ist durch die Blockoberfläche, die Gleichmäßigkeit des kristallinen Blockaufbaus und die Homogenität der chemischen Zusammensetzung, ferner die Reinheit von Gasen, unerwünschten Spurenelementen, makro- und mikrokristallinen Einschlüssen und anderen Verunreinigungen sowie die verbesserten mechanischen Eigenschaften, wie Duktilität und Anisotropie der Festigkeitswerte, so wird sie durch kaum ein anderes Verfahren übertroffen.

Um diese Qualität eines geschmolzenen Blocks zu erhöhen, sind verschiedene Schweiß-, Schmelz- und Oberflächenvergütungsverfahren vorgeschlagen worden (DE-OS 33 39 906, DD-PS 249 923, DD-PS 221 473, DD-PS 249 924, DD-PS 242 427; S. Schiller und S. Panzer: "Härten von Oberflächenbahnen mit Elektronenstrahlen" in HTM 42, 1987, 5, S. 293 bis 300; S. Panzer und M. Müller: "Härten von Oberflächen mit Elektronenstrahlen", HTM 43, 1988, 2, S. 103 bis 111; S. Schiller und S. Panzer: "Thermische Oberflächenmodifikation metallischer Bauteile mit Elektronenstrahlen", METALL, 39. Jahrgang, Heft 3, März 1985, S. 227 bis 232; Rolf Zenker und Matthias Müller: "Randschichthärten mit Elektronenstrahlen - Verfahrenstechnische Möglichkeiten und werkstofftechnische Effekte", Neue Hütte, 32. Jahrgang, Heft 4, April 1987, S. 127 bis 34; Siegfried Schiller: "Electron Beam Systems Scan at High Speeds", Metal Progress, April 1986, S. 39/40). Diese Verfahren haben jedoch mit der Brennfleck-Positionierung eines Elektronenstrahls und der damit verbundenen Möglichkeit des Tiegelschmelzens nur wenig zu tun.

Es ist weiterhin bekannt, das Elektronenstrahlschmelzen für einfache Blockschmelzen, für das Abtropfschmelzen, bei der Überlaufschmelze, beim Multistranggießen, beim Pelletisieren, beim Schmelzen in zwei getrennten Kammern und zum Reinigen zu verwenden (Neue Hütte, Heft 11, 16. Jahrgang, November 1971, S. 650 bis 657). Bei allen diesen Verfahren ist es wichtig, daß der Elektronenstrahl, der durch seine Ablenkeinheit einen vorgegebenen Aktionsradius besitzt, nur innerhalb gewisser räumlicher Grenzen auf das zu schmelzende Material auftrifft. Diese Grenzen können beispielsweise durch einen Tiegelrand, die Konturen einer Zwischenpfanne oder den Rand einer Strangguß-Kokille vorgegeben sein. Trifft der Elektronenstrahl Gegenstände außerhalb dieser Grenzen, so können große Schäden entstehen.

Für die Darstellung eines Tiegelrands ist es bereits bekannt, einen mit einem Bildschirm verbundenen Speicher vorzusehen, in dem die Konturen des Tiegels abgespeichert sind (DE-OS 35 38 857). Hierbei werden die Konturen des Tiegels mittels des Teach-In-Verfahrens ermittelt, wobei z. B. die Erfassung der Konturen eines Rechtecktiegels in der Weise geschieht, daß ein Elektronenstrahl manuell in die Tiegelecken gelenkt wird und eine Recheneinrichtung durch lineare Interpolation zwischen den einzelnen Eckpositionen die Gesamtkontur ermittelt. Ein Weg, wie der Elektronenstrahl daran gehindert werden soll, einen bestimmten Bereich nicht zu verlassen, ist bei dieser bekannten Einrichtung, welche die Eingabe eines Positions-Sollwerts für den Auftreffpunkt eines Elektronenstrahls betrifft, nicht aufgezeigt.

Um den Elektronenstrahl nur auf den inneren Bereich eines Tiegels auftreffen zu lassen, genügt es in vielen Fällen, den inneren Bereich durch eine entsprechende Sollwert-Eingabe an der x-y-Ablenkung des Elektronenstrahls vorzugeben. Da jedoch stets eine Abweichung zwischen Soll- und Istwert besteht, kann eine Tiegelrandüberschreitung mit größerer Sicherheit unterbunden werden, wenn der Istwert des Auftreffpunkts des Elektronenstrahls erfaßt wird.

Eine Einrichtung zum Erkennen des Istwerts der Auftreffstelle eines Elektronenstrahls auf einem Target ist bereits bekannt (EP-Al-O 184 680). Hierbei werden die von der Auftreffstelle ausgehenden Röntgenstrahlen durch einen Detektor erkannt, der mit einer besonderen Auswerteschaltung verbunden ist. Mit Hilfe eines Abbildungssystems werden alle Positionen, welche die Auftreffstelle einnehmen kann, erfaßt und auf die Sensorfläche eines positionsempfindlichen Detektors gegeben. Es ist indessen auch bei dieser Einrichtung keine Lösung für das Problem gegeben, den Elektronenstrahl am Überschreiten vorgegebener Grenzen zu hindern.

Es ist weiterhin bekannt, die Strahlführung und die Leistung von Elektronenstrahlkanonen zu steuern, wobei eine Mikroprozessorsteuerung eingesetzt wird, mit der es möglich ist, bis zu fünf Elektronenstrahlkanonen gleichzeitig, aber mit individuellen Programmen, in ihrer Strahlungsverteilung zu steuern (W. Dietrich, H. Ranke, H. Stumpp: Strahlführung und Leistungssteuerung von Elektronenstrahlkanonen bis 600 kW und deren Einsatz in der industriellen Produktion, Optik, Vol. 77, Nr. 4, November 1987, S. 156 - 170). Um eine direkte Programmierung von Strahlverteilungen auf einem Bildschirm durchzuführen, werden hierbei die Tiegelkonturen zu Beginn einer ersten Inbetriebnahme eines Elektronenstrahlofens in ein Computersystem einprogrammiert. Zu diesem Zweck wird der Elektronenstrahl entlang den Tiegelrändern an diskreten Punkten positioniert, die mittels Tastendruck abgespeichert werden können. Diese Randpositionen werden nach Beendigung des Einlern-Prozesses automatisch mit Polygonzügen verbunden. Dadurch wird der Bildschirm in für den Elektronenstrahl erlaubte und unerlaubte Bereiche eingeteilt. Trifft der Elektronenstrahl, bedingt durch eine Fehlfunktion des Ablenkelements außerhalb des erlaubten Bereichs auf, führt dies sofort zu einer Spannungsabschaltung. Nachteilig ist bei dieser bekannten Bildschirmdarstellung, daß auf einen Videospeicher zurückgegriffen wird, der zeilenweise ausgelesen werden muß. Hierdurch ergeben sich unzulässig lange Abschaltzeiten für den Elektronenstrahl.

Der Erfindung liegt deshalb die Aufgabe zugrunde, eine Einrichtung mit einer speziellen Speicherstruktur zu schaffen, die es gestattet, daß der Elektronenstrahl sehr schnell abgeschaltet wird, wenn er den Bereich vorgegebener Konturen verläßt.

Diese Aufgabe wird gemäß den Merkmalen der Patentansprüche 1 und 11 gelöst.

Der mit der Erfindung erzielte Vorteil besteht insbesondere darin, daß der Elektronenstrahl nicht in verbotene Zonen gelangen und dort Schaden anrichten kann, ohne daß hierfür mechanische Hilfsmittel wie Blenden und dergleichen erforderlich sind. Ein weiterer Vorteil liegt darin, daß die jeweils erfaßte Ist-Position des Elektronenstrahl-Auftreffpunkts nicht in analoge Tiegelkontur-Vergleichsschaltungen gegeben werden muß, was zwar zu einer schnellen Abschaltung des Elektronenstrahls führen könnte, aber verhindern würde, daß beliebig variable Konturen in einem Speicher ablegbar sind. Für die Erfassung und Abspeicherung variabler Konturen nach dem Teach-In-Verfahren eignet sich in besonderer Weise ein Rechner, der jedoch wegen der begrenzten Rechengeschwindigkeit für den Vergleich der Ist-Position des Elektronenstrahls mit den erlaubten Positionen nicht geeignet ist. Bei den für die Bearbeitung von Materialien durch Elektronenstrahl notwendigen Ablenkfrequenzen von bis zu 1000 Hz, entsprechend 1 ms Periodenzeit der Ablenkfigur und einer Auflösung von 1 ‰ des Umlaufs, bleibt nur eine Rechenzeit von 1 »s zur Berechnung der momentanen Position des Elektronenstrahls relativ zur Berandung. Für diese Aufgabe sind umfangreiche Berechnungen von Vektorfunktionen in der x-y-Ebene nötig. Diese Aufgabe wäre zwar mit einem Rechner hoher Leistung durchführbar, doch wäre der Rechner dann alleine mit dieser Überwachungsfunktion beschäftigt. Mit der Erfindung ist es dagegen möglich, zu überwachen, ob sich der Auftreffpunkt des Elektronenstrahls im erlaubten Bereich befindet, ohne einen Rechner während der aktiven Prozeßphase zu benötigen.

Ein Ausführungsbeispiel der Erfindung ist in der Zeichnung dargestellt und wird im folgenden näher beschrieben. Es zeigen:
- Fig. 1: eine Einrichtung für die Steuerung und Überwachung eines Elektronenstrahls;
- Fig. 2: eine Einrichtung gemäß Fig. 1, die aus einem Rechner und wenigstens einem Zusatzspeicher besteht.

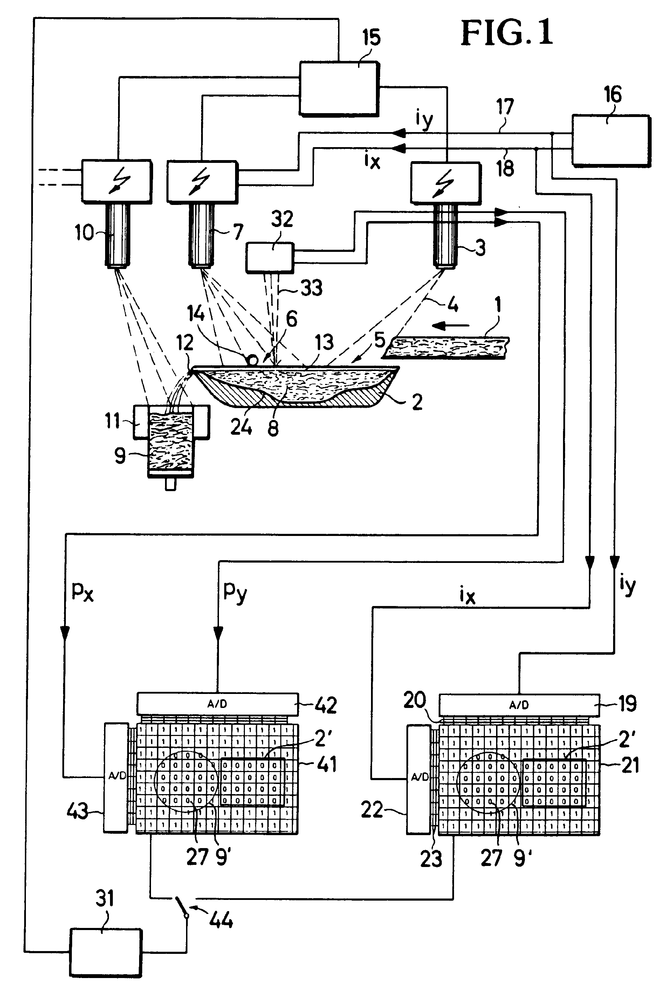

In der Fig. 1 ist ein zu schmelzender Metallstrang 1 dargestellt, der in Richtung auf eine Zwischenpfanne 2 bewegt wird und über dem sich eine Elektronenkanone 3 befindet, deren Elektronenstrahl 4 den Metallstrang 1 abschmilzt. Der Elektronenstrahl 4 kann abgelenkt werden und ermöglicht es so, das abgeschmolzene Metall im vorderen Bereich 5 der Zwischenpfanne 2 flüssig zu halten. Im hinteren Bereich 6 der Zwischenpfanne 2 ist eine weitere Elektronenkanone 7 vorgesehen, die das Schmelzgut 8 vor dem Ausgießen aus der Zwischenpfanne 2 in einen Stranggußtiegel 9 flüssig hält. Eine dritte Elektronenkanone 10 hält das in den Stranggußtiegel 9 ausgegossene Schmelzgut flüssig, wobei eine zusätzliche Heizeinrichtung 11 am oberen Rand des Tiegels 9 vorgesehen ist. Mit dieser Anordnung ist es möglich, eine Schweretrennung von ungelösten Komponenten im Schmelzbad vorzunehmen. Die schweren Einschlüsse sinken auf den Boden der Zwischenpfanne 2 und können den Damm 24 vor einer Auslauflippe 12 nicht überwinden. Die leichten, auf dem Schmelzbad schwimmenden Schlacketeilchen 13 werden von einem als Abstreifer wirkenden gekühlten Metallrohr 14 zurückgehalten; sie gelangen also nicht in das Schmelzbad des Stranggußtiegels 9. Durch entsprechende Verteilung der Elektronenstrahlleistung auf dem Schmelzbad der Zwischenpfanne 2 kann die Badtiefe so flach gehalten werden, daß infolge des dann geringen liquostatischen Drucks eine optimale, dem Vakuumdruck entsprechende Entgasung möglich ist.

Die Energieversorgung der Elektronenkanonen 3, 7, 10 erfolgt über eine Hochspannungseinrichtung 15. Für die x-y-Steuerung der Elektronenkanonenstrahlen ist jeweils eine Steuereinrichtung 16 vorgesehen, deren Steuerleitungen 17, 18 in der Fig. 1 der Einfachheit halber nur auf die Elektronenkanone 7 geführt sind. Entsprechende separate Steuerleitungen werden auch auf die Elektronenkanonen 3 und/oder 10 geführt. Über die Steuerleitungen 17, 18 werden Ablenkströme iₓ, i_{y} gegeben, die den Auftreffpunkt eines Elektronenstrahls auf das Schmelzgut 8 bestimmen. Der analoge Ablenkstrom iₓ kann auf einen Analog-Digital-Wandler 22 gegeben werden, der den analogen iₓ-Wert in einen digitalen Wert umsetzt und über Leitungen 23 den x-Spalten eines Speichers 21 zuführt, der matrixartig aufgebaut ist. In entsprechender Weise kann der analoge Strom i_{y} über einen zweiten Analog-Digital-Wandler 19 in ein digitales Signal umgewandelt und über Leitungen 20 den y-Spalten des Speichers 21 zugeführt werden.

Bei dem Speicher 21 handelt es sich vorzugsweise um einen elektronischen RAM-Speicher; es ist jedoch auch möglich, jeden anderen Speicher zu verwenden, der beschrieben und ausgelesen werden kann, z. B. ein EEPROM-Speicher. Die erlaubten Zonen, in denen sich die Elektronenstrahlen der Elektronenkanonen 3, 7, 10 bewegen dürfen, sind z. B. durch die äußeren Konturen des Tiegels 9 oder der Zwischenpfanne 2 vorgegeben. Außerhalb dieser Konturen darf ein Elektronenstrahl nicht gelangen. Da jedoch der Aktionsradius eines Elektronenstrahls größer ist als der erlaubte Bereich, müssen Maßnahmen getroffen werden, um ein Überschreiten des erlaubten Bereichs zu verhindern.

Zu diesem Zweck sind die Konturen der erlaubten Bereiche im Speicher 21 abgebildet. Für die Abbildungen dienen dabei "1"- bzw. "0"-Informationen, die dort, wo sie aneinander grenzen, eine Kontur definieren.

Im Speicher 21 sind die Konturen des Tiegels 9 und der Zwischenpfanne 2 - wenn auch stilisiert - durch die Bezugszahlen 9′ und 2′ wiedergegeben. Alle erlaubten Bereiche sind mit einer "0"-Information versehen, während alle verbotenen Bereiche mit einer "1"-Information versehen sind.

Allerdings geben die iₓ-, i_{y}-Werte für den Elektronenstrahl-Auftreffpunkt oft nur eine ungenaue Information über den tatsächlichen Auftreffpunkt. Besser ist es deshalb, anstelle der Ablenkströme iₓ, i_{y} die Positionsistwerte Pₓ, P_{y} für die Ansteuerung eines Speichers zu wählen. Diese Istwerte Pₓ, P_{y} werden beispielsweise mittels einer Positions-Istwert-Erkennungseinrichtung 32 ermittelt, welche die Röntgenstrahlen 33, die beim Aufprall von Elektronen auf Materie entstehen, erfaßt und auswertet. In der Einrichtung 32 befinden sich ein positionsempfindlicher Detektor, beispielsweise eine Lateraldiode, sowie eine spezielle Auswerteschaltung, welche Pₓ- und P_{y}-Positionssignale liefert. Einzelheiten dieser Einrichtung sind in der europäischen Patentveröffentlichung EP-Al-0 184 680 beschrieben. In der Fig. 1 ist lediglich der Elektronenstrahlkanone 7 eine Positions-Istwert-Erkennungseinrichtung 32 zugeordnet. In entsprechender Weise kann jedoch auch den anderen Elektronenstrahlkanonen 3, 10 eine Istwert-Erkennungseinrichtung zugeordnet werden.

Bei der Verwendung einer Einrichtung, welche exakt den Ist-Wert der Auftreff-Position des Elektronenstrahls ermittelt, kann mit großer Sicherheit festgestellt werden, ob sich der Elektronenstrahl noch innerhalb oder schon außerhalb der erlaubten Gebiete befindet.

Für die Positions-Istwert-Eingabe ist ein eigener Speicher 41 vorgesehen, der genauso strukturiert ist wie der Speicher 21. Er ist mit Analog-Digital-Wandlern 42, 43 verbunden, welche die analogen Positions-Istwerte in digitale Werte umformen. Beide Speicher 21, 41 können einzeln verwendet werden. Besonders vorteilhaft ist es jedoch, sie zusammen zu verwenden. Sollte der genauere Positions-Istwert ausfallen, so könnte auf die Ablenkströme umgeschaltet werden. Für eine solche Umschaltung ist ein Umschalter 44 vorgesehen, der einmal den Speicher 41 und einmal den Speicher 21 mit einer Einrichtung 31 verbindet, die mit der Hochspannungseinrichtung 15 in Verbindung steht.

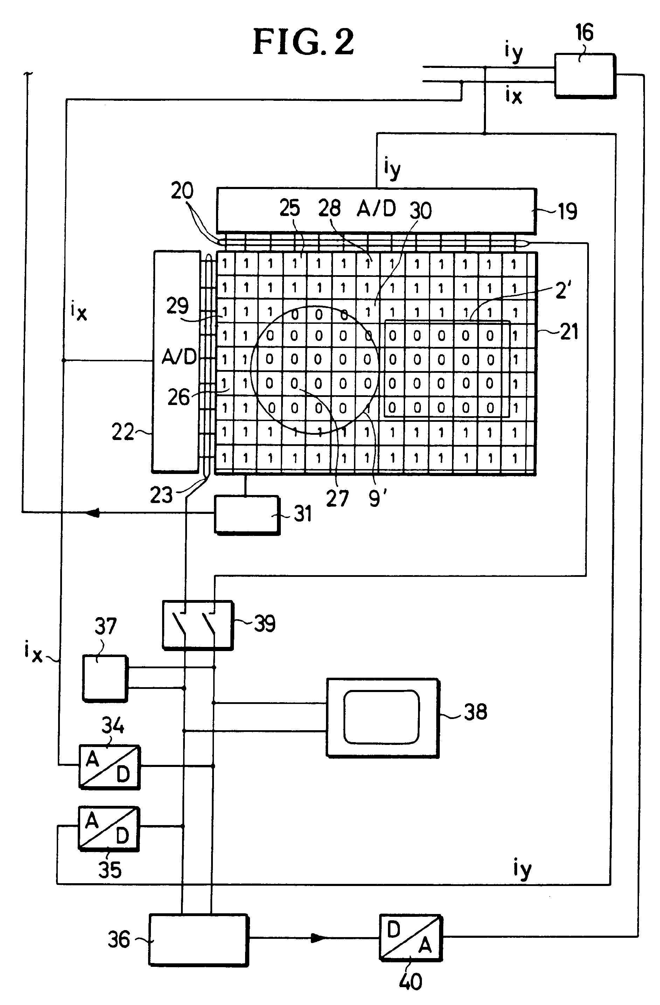

Anhand der Fig. 2 wird die Eingabe von Informationen in einen Speicher 21, 41 der besseren Übersichtlichkeit wegen nur in bezug auf den Speicher 21 näher beschrieben. Die Ausführungen gelten jedoch auch in entsprechender Weise für den Speicher 41.

Es sei angenommen, daß der i_{y}-Wert derart ist, daß die senkrechte Spalte 25 angesteuert wird, während aufgrund des iₓ-Werts die waagerechte Zeile 26 beaufschlagt wird. In diesem Fall treffen beide Signale im Punkt 27 zusammen, wo sich eine "0"-Information befindet. Dies bedeutet, daß sich der Elektronenstrahl in der erlaubten Zone aufhält.

Führt der aktuelle Ablenkstrom i_{y} dagegen auf die Spalte 28, während der aktuelle Ablenkstrom iₓ die Zeile 29 ansteuert, so treffen sich die Werte der beiden Ströme im Punkt 30, der einen verbotenen Bereich kennzeichnet, weil dort eine "1"-Information gespeichert ist. Dieses Treffen der x- und y-Signale in einem "1"-Punkt wird von der Einrichtung 31 erkannt, die hierauf ein Signal an die Hochspannungseinrichtung 15 gibt und diese schlagartig von der Elektronenkanone 7 trennt. Hierdurch wird vermieden, daß der Elektronenstrahl, der sich aus dem erlaubten Bereich entfernt, Schaden anrichten kann.

Bisher wurde davon ausgegangen, daß die Flächen von Tiegel 9 bzw. Zwischenpfanne 2 bereits im Speicher 21 abgelegt sind. Im folgenden wird beschrieben, wie die Eingabe der Konturen in einen Speicher 37 und die Eingabe der Flächen in den Speicher 21, der beispielsweise 256 x 256 Speicherplätze besitzt, erfolgt.

Per Hand wird der Elektronenstrahl einer Elektronenkanone, z. B. der Elektronenkanone 7, vom Tiegel-Innenbereich auf den Rand bzw. auf die äußere Kontur dieses Tiegels hinbewegt. Da der Elektronenstrahl nur Meßfunktionen ausübt, kann er wesentlich schwächer sein als im normalen Metall-Schmelzbetrieb. Hat der Elektronenstrahl den Tiegelrand erreicht, so kann eine Taste gedrückt und der Ablenkstrom-Istwert iₓ, i_{y} über Digital-Analog-Wandler 34, 35 einem Rechner 36 zugeführt werden.

Dieses Verfahren wird für mehrere markante Punkte entlang des Tiegelrands wiederholt, wobei die jeweiligen Koordinaten dem Rechner 36 zugeführt werden. Die verschiedenen Punkte werden sodann durch den Rechner durch Interpolation zu einem geschlossenen Kurvenzug ergänzt. Das Interpolationsverfahren sollte dabei die gespeicherten Punkte nicht nur linear untereinander verbinden können, sondern auch die Darstellung einer runden Tiegelform durch Abspeichern von nur wenigen Stützwerten ermöglichen. Um mehrere Punkte in einem kartesischen Koordinatensystem zu einer Funktion f(x) durch einen Kurvenzug zu verbinden, bieten sich mehrere Verfahren an, beispielsweise der Newton'sche Interpolationsalgorithmus, der für Funktionen mit geringer Stützstellenzahl geeignet ist. Weist dagegen die Funktion z. B. 20 Stützstellen auf, so wird durch diese Punkte eine Kurvengleichung berechnet, die schon 21. Grades ist. Da außer der Festlegung an den Stützstellen an des Newton'sche Polynom keine weiteren Anforderungen gestellt sind, oszilliert dieses bei einer größeren Stützstellenzahl im Bereich zwischen zwei Werten.

In diesem Fall empfiehlt sich die Anwendung von interpolierenden Spline-Funktionen. Eine Funktion f(x) wird dann zur interpolierenden Spline-Funktion k-ten Grades, wenn f(x) (k-1)mal stetig differenzierbar ist, zwischen zwei Stützwerten durch ein Polynom höchstens k-ten Grades gegeben wird und die Interpolationseigenschaft f(xᵢ) = yᵢ für i = 0, 1, ... n erfüllt (vgl. c't 1987, Heft 6, S. 120 ff.: "Auf die krumme Tour", Kubische SPLINE-Interpolation in TURBO-PASCAL).

Zur optimalen Findung der Konturen können beide Interpolationsverfahren - das Spline-Verfahren und das lineare Verfahren - kombiniert verwendet werden.

Die von dem Rechner 36 ermittelte Kontur wird nun in einem Speicher 37 abgelegt und im Bedarfsfall auf einem Monitor 38 dargestellt. Eine Flächenfüllroutine kann im Rechner 36 nun den Inhalt aller Flächenelemente des Speichers 21 berechnen. Über die Torschaltung 39 wird der Speicher 21 sodann beschrieben. Nach der Übergabe ist der Rechner 36 frei für weitere Steuerungsaufgaben, d. h. er kann beispielsweise über einen Digital-Analog-Wandler 40 die Steuereinrichtung 16 mit Befehlen beaufschlagen oder ganz entfernt werden. Der errechnete Kurvenzug der Tiegelform befindet sich bei der grafischen Darstellung auf dem Monitor 38 bereits im Konturspeicher 37, wobei der gesamte Tiegelbereich auf einer Fläche von 256 x 256 Bildschirmpixeln sichtbar ist.

Somit wird durch die Verwendung eines Speichers 21, in dem die Flächen der erlaubten Bereiche für die Auftreffstelle eines Elektronenstrahls abgelegt sind, der Rechner 36 erheblich entlastet, so daß er für andere Aufgaben zur Verfügung steht. Lediglich während der Anfahr-Phase einer Elektronenstrahl-Schmelzanlage wird mit Hilfe des Einlernvorgangs oder Teach-In-Verfahrens die Berandung der Arbeitszone in den Rechner 36 eingegeben. Nach der Umrechnung dieser Berandung wird das gesamte Sichtfeld des Positions-Detektors 32 bzw. das Aktionsfeld des Elektronenstrahls in verbotene und erlaubte Arbeitszonen eingeteilt und als x-y-Matrix in dem Speicher 21 niedergelegt. Während des Schmelzvorgangs werden die x- und y-Ist-Positionen an den Speicher 21 gegeben, der die Information "erlaubt/verboten" liefert. Die erfindungsgemäße Einrichtung ermöglicht es auf diese Weise, die eigentliche Überwachung des Elektronenstrahls durchzuführen, ohne den Rechner 36 zu belasten. In einem Zeitraum von ca. einer Sekunde wird vor dem Beginn des Schmelzprozesses die Rechenarbeit erledigt, indem die eingelernte Kontur in eine Fläche und daraus die Flächenelemente in verbotene und erlaubte Aufenthaltszonen eingeteilt werden. Eine gute Auflösung wird bereits mit 256 x 256 Speicherelementen erreicht, die durch einen einzigen integrierten RAM-Speicher-IC realisiert werden können. In den Fig. 1 und 2 sind nur wenige dieser Speicherelemente exemplarisch dargestellt. Wenn man die derzeit einfachsten RAM-Speicher verwendet, so benötigt man zur Ausfrage ca. 500 ns, wobei die Ausfragezeit durch Einsatz von Hochgeschwindigkeitsspeichern auf unter 50 ns gesenkt werden kann.

Die Organisation 256 x 256 Speicherplätze des Speichers 21 wird dadurch nahegelegt, daß die beiden Ablenkstrom-Istwerte iₓ, i_{y} in je acht Bit aufgelöst werden. Speicher mit dieser Speicherkapazität sind als 64-kbit-Speicher leicht erhältlich, die neben verschiedenen Steuereingängen 16 Adreßeingänge und je einen Datenein- und -ausgang besitzen.

Die Fig. 2 wurde anhand der Ablenkstrom-Istwerte iₓ, i_{y} beschrieben. Es versteht sich jedoch, daß die Verarbeitung der Ausgangssignale Pₓ, P_{y} der Positions-Istwert-Erkennungseinrichtung 32 auf entsprechende Weise erfolgen kann.

## Patentansprüche

1. Einrichtung für die Steuerung und Überwachung eines ablenkbaren Elektronenstrahls (4) für die Metallbearbeitung, der einen vorgebbaren Aktionsbereich besitzt, wobei dieser Aktionsbereich einen ersten Bereich einschließt, der für den Elektronenstrahl erlaubt ist, sowie einen zweiten Bereich, der für den Elektronenstrahl verboten ist, wobei der Elektronenstrahl (4) abgeschaltet oder in den erlaubten Bereich zurückgebracht wird, wenn er sich in dem verbotenen Bereich befindet, **dadurch gekennzeichnet**, daß
a) der erste und der zweite Bereich Zonen auf einer metallischen Oberfläche und durch Konturen (2, 9) definiert sind;
b) ein erster Speicher (21, 41) vorgesehen ist, der mehrere Speicherelemente zum Speichern von zwei verschiedenen Arten von Daten aufnimmt, um einen Aktionsbereich des Elektronenstrahls (4) abzugrenzen, wobei in einem ersten Bereich des ersten Speichers (21) die Speicherelemente eine erste Datenart (27) speichern, und wobei in einem zweiten Bereich des ersten Speichers die Speicherelemente eine zweite Datenart speichern, wobei eine Grenze (9′) zwischen den Bereichen des ersten Speichers dazu dient, zwischen den erlaubten und den verbotenen Zonen zu unterscheiden;
c) eine Einrichtung zum Erkennen der tatsächlichen Position des Elektronenstrahls (4) und zum Erzeugen digitaler Daten, welche einen Bereich innerhalb des ersten Speichers definieren, vorgesehen ist;
d) eine Einrichtung (31) zum Erkennen, ob die digital definierte Position innerhalb des erlaubten oder innerhalb des verbotenen Bereichs des ersten Speichers (21, 41) liegt.

2. Einrichtung nach Anspruch 1, **dadurch gekennzeichnet**, daß die erlaubten Speicherbereiche von einer ersten Datenart belegt sind, z. B. "0", während die verbotenen Speicherbereiche durch eine zweite Datenart belegt sind, z. B. "1".

3. Einrichtung nach Anspruch 1, **dadurch gekennzeichnet**, daß der Elektronenstrahl (4) über eine Steuereinrichtung (16) mit Ablenkströmen (iₓ, i_{y}) den Auftreffpunkt des Elektronenstrahls (4) darstellt, daß der Ablenkstrom (iₓ, i_{y}) dem Speicher (21) zugeführt wird und daß dann, wenn der Auftreffpunkt innerhalb eines verbotenen Bereichs liegt, der Elektronenstrahl (4) abgeschaltet und/oder in den erlaubten Bereich zurückgefahren wird.

4. Einrichtung nach Anspruch 1, **dadurch gekennzeichnet**, daß ein Detektor (32) vorgesehen ist, der den Istwert (Pₓ, P_{y}) des Auftreffpunkts des Elektronenstrahls (4) auf Materie erkennt und diesen Istwert (Pₓ, P_{y}) dem Speicher (41) zuführt, wobei dann, wenn der Istwert außerhalb des erlaubten Bereichs liegt, der Elektronenstrahl (4) abgeschaltet und/oder in den erlaubten Bereich zurückgefahren wird.

5. Einrichtung nach Anspruch 1, **dadurch gekennzeichnet**, daß die abgespeicherten Konturen den Rändern von Behältern (2, 9) entsprechen, wobei diese Ränder für die Positions- und/oder zugehörigen Ablenkstromwerte mittels eines Teach-In-Verfahrens ermittelt und in einem Speicher (37) abgelegt werden.

6. Einrichtung nach Anspruch 5, **dadurch gekennzeichnet**, daß das Teach-In-Verfahren mittels eines Rechners (36) durchgeführt wird.

7. Einrichtung nach Anspruch 1, **dadurch gekennzeichnet**, daß die Konturen zwischen erlaubten und verbotenen Bereichen auf einem optischen Anzeigegerät (38) sichtbar dargestellt sind.

8. Einrichtung nach Anspruch 2, **dadurch gekennzeichnet**, daß der Speicher (21, 41), in dem die erlaubten und verbotenen Flächen abgespeichert sind, ein RAM-Speicher ist.

9. Einrichtung nach Anspruch 2, **dadurch gekennzeichnet**, daß der Speicher (21, 41), in dem die erlaubten und verbotenen Flächen abgespeichert sind, ein EEPROM-Speicher ist.

10. Einrichtung nach den Anspruch 1 bis 4, **dadurch gekennzeichnet**, daß zwei Speicher (21, 41) vorgesehen sind, von denen der eine mit Ablenkströmen (iₓ, i_{y}) als Elektronenstrahl-Positions-Istwerten und der andere mit Positions-Istwerten (Pₓ, P_{y}) aus einem Positions-Istwertgeber (32) beaufschlagt wird, und daß ein Umschalter (44) vorgesehen ist, mit dem der eine oder der andere Speicher (21, 41) an eine Einrichtung (15) zum Abschalten des Elektronenstrahls (4) angeschaltet wird.

11. Einrichtung für die Steuerung und Überwachung eines ablenkbaren Elektronenstrahls für die Metallbearbeitung, der einen vorgegebenen Aktionsbereich besitzt, wobei der Aktionsbereich in erlaubte und verbotene Bereiche aufgeteilt ist und den Elektronenstrahl (4) dann, wenn er sich in einem verbotenen Bereich befindet, abgeschaltet oder in eine erlaubte Zone zurückgeführt wird, **dadurch gekennzeichnet**, daß zwei Speicher vorgesehen sind, von denen der eine mit Ablenkströmen (iₓ, i_{y}) als Elektronenstrahl-Istwertpositionen beaufschlagt wird, während der andere von Ist-Positionswerten (Pₓ, P_{y}) einer Positions-Istwertausgabe beaufschlagt wird, und daß ein Umschalter vorgesehen ist, mit dem der eine oder andere Speicher mit einer Einrichtung zum Abschalten des Elektronenstrahls (4) verbunden ist.

## Claims

1. Device for controlling and monitoring a deflectable electron beam (4) for metal working, which electron beam has a predeterminable operating range, this operating range including a first range which is permitted for the electron beam and a second range which is forbidden to the electron beam, the electron beam (4) being switched off or brought back into the permitted range when it is in the forbidden range, characterized in that
a) the first and the second range are zones on a metal surface and are defined by contours (2, 9);
b) a first storage device (21, 41) is provided which receives a plurality of storage elements for storing two different types of data in order to delimit an operating range of the electron beam (4), in a first range of the first storage device (21) the storage elements storing a first type of data (27) and in a second range of the first storage device the storage elements storing a second type of data, a border (9′) between the ranges of the first storage device serving to differentiate between the permitted and the forbidden zones;
c) a device is provided for recognizing the actual position of the electron beam (4) and for generating digital data which define a range within the first storage device;
d) a device (31) for recognizing whether the digitally defined position lies within the permitted or within the forbidden range of the first storage device (21, 41).

2. Device according to Claim 1, characterized in that the permitted storage ranges are occupied by a first type of data, e.g. "0", while the forbidden storage ranges are occupied by a second type of data, e.g. "1".

3. Device according to Claim 1, characterized in that the electron beam (4) represents, by way of a control device (16) having deflection currents (iₓ, i_{y}), the impact point of the electron beam (4), in that the deflection current (iₓ, i_{y}) is supplied to the storage device (21), and in that when the impact point lies within a forbidden range the electron beam (4) is switched off and/or brought back into the permitted range.

4. Device according to Claim 1, characterized in that a detector (32) is provided which recognizes the actual value (Pₓ, P_{y}) of the impact point of the electron beam (4) on matter and supplies this actual value (Pₓ, P_{y}) to the storage device (41), and when the actual value lies outside the permitted range the electron beam (4) is switched off and/or brought back into the permitted range.

5. Device according to Claim 1, characterized in that the stored contours correspond to the edges of containers (2, 9), these edges being determined for the position values and/or associated deflection current values by means of a teach-in process and being stored in a storage device (37).

6. Device according to Claim 5, characterized in that the teach-in process is carried out by means of a computer (36).

7. Device according to Claim 1, characterized in that the contours between permitted and forbidden ranges are produced visually on a display unit (38).

8. Device according to Claim 2, characterized in that the storage device (21, 41) in which the permitted and forbidden areas are stored is a RAM storage device.

9. Device according to Claim 2, characterized in that the storage device (21, 41) in which the permitted and forbidden areas are stored is an EEPROM storage device.

10. Device according to Claim 1 to 4, characterized in that two storage devices (21, 41) are provided, of which the one is supplied with deflection currents (i_{y}, i_{y}) as electron beam position actual values and the other is supplied with position actual values (Pₓ, P_{y}) from a position actual value transmitter (32), and in that a change-over switch (44) is provided by means of which the one or the other storage device (21, 41) is connected to a device (15) for switching off the electron beam (4).

11. Device for controlling and monitoring a deflectable electron beam for metal working, which electron beam has a predetermined operating range, the operating range being divided into permitted and forbidden ranges and the electron beam (4) being switched off or brought back into a permitted zone when it is in a forbidden range, characterized in that two storage devices are provided, of which one is supplied with deflection currents (iₓ, i_{y}) as electron beam actual value positions, while the other is supplied by actual position values (Pₓ, P_{y}) of a position actual value output, and in that a change-over switch is provided by means of which the one or the other storage device is joined to a device for switching off the electron beam (4).

## Revendications

1. Dispositif de commande et de contrôle d'un faisceau d'électrons (4) pouvant être dévié, pour le traitement des métaux, qui possède un secteur d'action pouvant être prédéterminé, ce secteur d'action comprenant un premier secteur qui est autorisé au faisceau d'électrons, ainsi qu'un second secteur qui est interdit au faisceau d'électrons, le faisceau d'électrons (4) étant arrêté ou ramené dans le secteur autorisé s'il se trouve dans le secteur interdit, caractérisé en ce que
a) le premier secteur et le second secteur sont des zones sur une surface métallique et sont définis par des contours (2, 9) ;
b) il est prévu une première mémoire (21, 41) qui contient plusieurs éléments de mémoire pour l'enregistrement de deux types différents de données afin de délimiter un secteur d'action du faisceau d'électrons (4), les éléments de mémoire enregistrant un premier type de données (27) dans une première zone de la première mémoire (21), et les éléments de mémoire enregistrant un second type de données dans une seconde zone de la première mémoire, une limite (9′) entre les zones de la première mémoire servant à distinguer les secteurs autorisés et interdits ;
c) il est prévu des moyens pour la détection de la position effective du faisceau d'électrons (4) et pour la génération de données numériques qui définissent un secteur à l'intérieur de la première mémoire ;
d) un dispositif (31) est prévu pour détecter si la position définie de façon numérique se situe à l'intérieur de la zone autorisée ou de la zone interdite de la première mémoire (21, 41).

2. Dispositif selon la revendication 1, caractérisé en ce que les zones de mémoire autorisées sont occupées par un premier type de données, par exemple "0", alors que les zones de mémoire interdites sont occupées par un second type de données, par exemple "1".

3. Dispositif selon la revendication 1, caractérisé en ce que le faisceau d'électrons (4) représente, par l'intermédiaire d'une installation de commande (16) avec des courants de déviation (iₓ, i_{y}), le point d'impact du faisceau d'électrons (4), en ce que le courant de déviation (iₓ, i_{y}) est amené à la mémoire (21) et en ce que lorsque le point d'impact se situe à l'intérieur d'un secteur interdit, le faisceau d'électrons (4) est arrêté et/ou ramené dans le secteur autorisé.

4. Dispositif selon la revendication 1, caractérisé en ce qu'il est prévu un détecteur (32), qui détecte la valeur réelle (Pₓ, P_{y}) du point d'impact du faisceau d'électrons (4) sur la matière et transmet cette valeur réelle (Pₓ, P_{y}) à la mémoire (41), le faisceau d'électrons (4) étant arrêté et/ou ramené dans le secteur autorisé si la valeur réelle se situe en-dehors du secteur autorisé.

5. Dispositif selon la revendication 1, caractérisé en ce que les contours enregistrés correspondent aux bords de réservoirs (2, 9), les valeurs de position et/ou les valeurs de courant de déviation correspondantes de ces bords étant déterminées au moyen d'un procédé d'apprentissage et enregistrées dans une mémoire (37).

6. Dispositif selon la revendication 5, caractérisé en ce que le procédé d'apprentissage est réalisé au moyen d'un calculateur (36).

7. Dispositif selon la revendication 1, caractérisé en ce que les contours entre les secteurs autorisés et interdits sont représentés de manière visible sur un appareil d'affichage optique (38).

8. Dispositif selon la revendication 2, caractérisé en ce que la mémoire (21, 41) dans laquelle les surfaces autorisées et interdites sont enregistrées est une mémoire RAM.

9. Dispositif selon la revendication 2, caractérisé en ce que la mémoire (21, 41) dans laquelle les surfaces autorisées et interdites sont enregistrées est une mémoire EEPROM.

10. Dispositif selon l'une des revendications 1 à 4, caractérisé en ce qu'il est prévu deux mémoires (21, 41) dont l'une est sollicitée par les courants de déviation (iₓ, i_{y}) représentant les valeurs réelles de la position du faisceau d'électrons et l'autre par des valeurs réelles de position (Pₓ, P_{y}) sur un indicateur de valeur réelle de position (32), et en ce qu'il est prévu un commutateur (44) par lequel l'une ou l'autre mémoire (21, 41) est connectée à un dispositif (15) pour l'arrêt du faisceau d'électrons (4).

11. Dispositif de commande et de contrôle d'un faisceau d'électrons pouvant être dévié, pour le traitement des métaux, qui possède un secteur d'action pouvant être prédéterminé, ce secteur d'action étant divisé en secteurs autorisés et secteurs interdits et le faisceau d'électrons (4) étant arrêté ou ramené dans une zone autorisée lorsqu'il se trouve dans un secteur interdit, caractérisé en ce qu'il est prévu deux mémoires, dont l'une est sollicitée par les courants de déviation (iₓ, i_{y}) représentant les valeurs réelles de la position du faisceau d'électrons, alors que l'autre est sollicitée par des valeurs réelles de position (Pₓ, P_{y}) sur un indicateur de valeur réelle de position, et en ce qu'il est prévu un commutateur par lequel l'une ou l'autre mémoire (21, 41) est connectée à un dispositif (15) pour l'arrêt du faisceau d'électrons (4).
